# EUROPÄISCHE PATENTANMELDUNG

(11) **EP 2 403 008 A1**
(43) Veröffentlichungstag der Anmeldung: **04.01.2012**
(21) Anmeldenummer: 10168106.2
(22) Anmeldetag: 01.07.2010
(51) Int. Cl.: H01L 31/048

(54) **Deckschicht für Solarzelle**

(71) Anmelder: Sika Technology AG, 6340 Baar (CH)
(72) Erfinder: Meier, Heinz, 8032, Zürich (CH); Blank, Norman, 8803, Rüschlikon (CH)
(74) Vertreter: Sika Patent Attorneys

(57) **Zusammenfassung**

Bei einem Modul (1) umfassend mindestens eine auf einem Träger (2) angeordnete Solarzelle (3) ist eine Deckschicht (4) angeordnet ist, welche Seitenlaschen (5) und Ecklaschen (6) aufweist, welche auf der Rückseite des Trägers aufgebracht miteinander in Kontakt sind.

## Beschreibung

### Technisches Gebiet

Die Erfindung geht aus von einem Modul umfassend eine auf einem Träger angeordnete Solarzelle sowie eine Deckschicht nach dem Oberbegriff des ersten Anspruches.

### Stand der Technik

Solarmodule mit auf Trägern aufgebrachten Solarzellen werden häufig mit einer Deckschicht überzogen, um die Solarzellen vor Feuchtigkeit und Schmutz zu schützen.

Insbesondere aufgrund von mechanischen Spannungen und Witterungseinflüssen kann sich die Deckschicht seitlich von dem Träger lösen, womit Feuchtigkeit zwischen Deckschicht und Träger eindringen kann und die Solarzelle beschädigt.

Erwähnte Spannungen sind insbesondere bedingt durch horizontales und vertikales Verschieben gegeneinander von Solarzelle und Träger, insbesondere wegen unterschiedlicher thermischer Längenausdehnungskoeffizienten. Solche Spannungen treten insbesondere bei Erwärmung durch intensive Sonneneinstrahlung, durch Wärmeerzeugung der Solarzelle selbst und bei tiefen Aussentemperaturen auf.

Weiter führt der Umstand, dass der chemische und/oder physikalische Verbund von Deckschicht und Träger äusseren Einflüssen wie Klima und UV-Stahlung ausgesetzt ist, dazu, dass der Verbund durch ebensolche mit der Zeit geschädigt wird, insbesondere dadurch, dass die Deckschicht typischerweise UV-durchlässig ist.

### Darstellung der Erfindung

Aufgabe der vorliegenden Erfindung ist es daher, ein Modul der eingangs genannten Art dahingehend zu verbessern, das Ablösen von der auf dem Träger aufgebrachten Deckschicht und infolgedessen das Eindringen von Feuchtigkeit zu minimieren.

Erfindungsgemäss wird dies durch die Merkmale des ersten Anspruches erreicht.

Kern der Erfindung ist es also, dass bei einem Modul, welches mindestens eine, auf einem Träger angeordnete Solarzelle sowie eine Deckschicht, welche auf der dem Träger abgewandten Seite der Solarzelle angebracht ist, umfasst, die Deckschicht Seitenlaschen, Ecklaschen und Aussparungen aufweist. Dabei bildet eine Aussparung jeweils eine Seitenkante einer Seitenlasche, resp. eine Seitenkante einer Ecklasche. Die Seitenlaschen und Ecklaschen sind durch eine entsprechende Faltlinie getrennt und auf der der Solarzelle abgewandten Seite des Trägers angeordnet, wobei die von einer Aussparung gebildeten Seitenkanten der entsprechenden Seitenlasche und Ecklasche miteinander in Kontakt sind.

Dies ist dahingehend von Vorteil, dass aufgrund der Seitenlaschen und Ecklaschen der Diffusionsweg zur Solarzelle von zwischen Deckschicht und Träger eindringender Feuchtigkeit erheblich verlängert wird.

Ferner verbessert die Tatsache, dass die Seitenkanten der entsprechenden Seitenlasche und Ecklasche miteinander in Kontakt sind, den Schutz vor eindringender Feuchtigkeit weiter.

Durch das Anordnen der Seiten- und Ecklaschen auf der der Solarzelle abgewandten Seite des Trägers wird der Verbund vor äusseren Einflüssen wie Klima, UV-Stahlung und insbesondere direktem Regen geschützt.

Es ist besonders zweckmässig, wenn die Seitenkanten der Ecklaschen die entsprechenden Seitenkanten der benachbarten Seitenlaschen überlappen, insbesondere entlang der gesamten Seitenkanten der Seitenlaschen überlappen. Dies führt im Überlappungsbereich zu einer weiteren Erhöhung des Diffusionswegs zur Solarzelle für eindringende Flüssigkeit.

Es ist weiter vorteilhaft, dass die Faltlinie der Ecklaschen die Faltlinie der benachbarten Seitenlaschen schneidet, insbesondere an einer Stelle der Faltlinie der Seitenlasche, die 3-15 mm vom Berührungspunkt der Seitenkanten der entsprechenden Seitenlasche und Ecklasche aus gemessen, entfernt ist. Dies führt im Schnittbereich der Faltlinien zu einer weiteren Erhöhung des Diffusionswegs zur Solarzelle für eindringende Flüssigkeit.

Weitere vorteilhafte Ausgestaltungen der Erfindung ergeben sich aus den Unteransprüchen.

### Kurze Beschreibung der Zeichnungen

Im Folgenden werden anhand der Zeichnungen Ausführungsbeispiele der Erfindung näher erläutert. Gleiche Elemente sind in den verschiedenen Figuren mit den gleichen Bezugszeichen versehen.
Es zeigen:
Fig. 1 Querschnitt durch ein Modul des Standes der Technik
Fig. 2-3 Querschnitte durch erfindungsgemässe Module
Fig. 4a - 7b Aufsicht der Solarzelle abgewandten Seite des Träger eines erfindungsgemässen Moduls vor, respektive nach, dem Anbringen der Seitenlaschen und Ecklaschen auf dem Träger.

Es sind nur die für das unmittelbare Verständnis der Erfindung wesentlichen Elemente gezeigt.

### Weg zur Ausführung der Erfindung

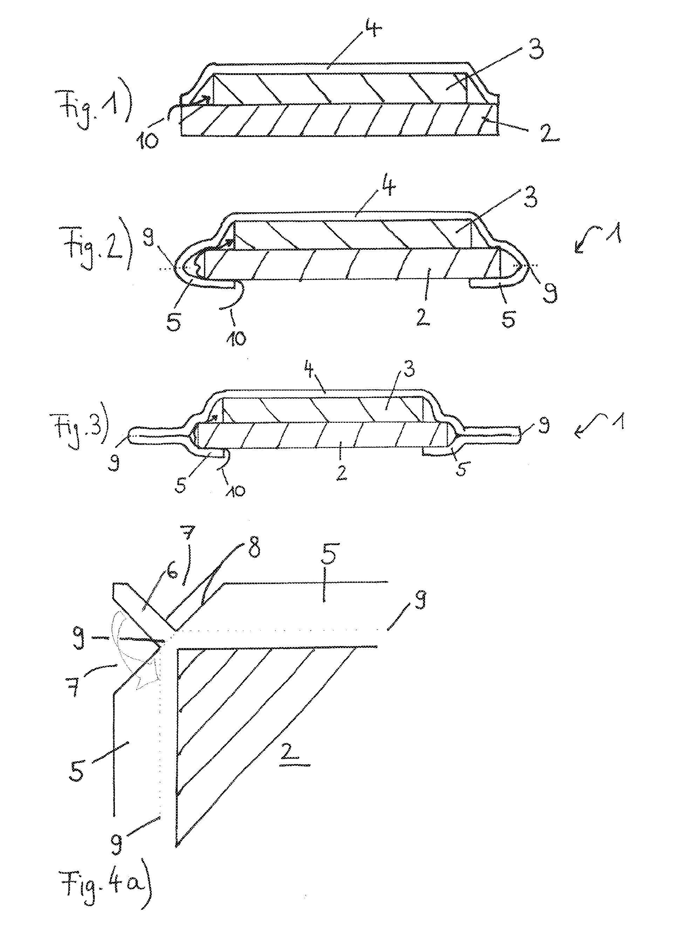

In der Figur 1 ist ein Querschnitt von einem Modul des Standes der Technik dargestellt, welche eine Deckschicht 4 aufweist, welche über der Solarzelle 3 angebracht ist und mit dem Träger 2 verbunden ist.

Figur 2 zeigt einen Querschnitt von einem erfindungsgemässen Modul 1, bei welchen die Deckschicht 4 über Seitenlaschen 5 auf der der Solarzelle 3 abgewandten Seite des Trägers 2 angeordnet sind. Figur 3 zeigt eine Variante von Figur 2 in welcher die Deckschicht seitlich auf sich selbst gefaltet ist. Dies ermöglicht eine einfachere Versiegelung des Trägers und der Solarzelle mit der Deckschicht.

Die Figuren 2 und 3 zeigen, im Vergleich zur Figur 1, einen wesentlich längeren Diffusionsweg für eindringende Flüssigkeiten 10. In den erfindungsgemässen Figuren muss die eindringende Flüssigkeit einerseits den Kontakt zwischen Seitenlasche 5 und Träger 2 sowie andererseits den Kontakt der Deckschicht 4 mit der der Solarzelle zugewandten Seite des Trägers überwinden, um zur Solarzelle 3 zu gelangen.

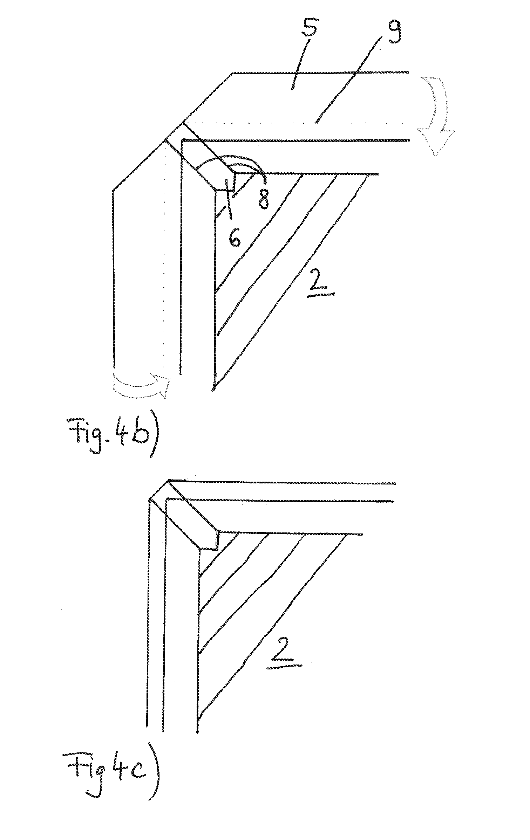

Figur 4a zeigt eine Aufsicht der Solarzelle abgewandten Seite des Träger eines erfindungsgemässen Moduls vor dem Anbringen der Seitenlaschen und der Ecklaschen auf dem Träger. In Figur 4b ist eine Ecklasche 6 bereits über die Faltlinie 9 gefaltet worden und befindet sich auf dem Träger 2. Figur 4c zeigt das Modul nach dem Falten der Seitenlaschen über die entsprechenden Faltlinien. Die von den Aussparungen 7 gebildeten Seitenkanten 8 der Seitenlaschen 5 und der Ecklasche 6 kommen in Figur 4c bündig nebeneinander auf dem Träger zu liegen und befinden sich dadurch miteinander in Kontakt. Dies schützt vor dem Eindringen von Feuchtigkeit im Bereich der Seitenkanten zwischen Deckschicht und der der Solarzelle abgewandten Seite des Trägers.

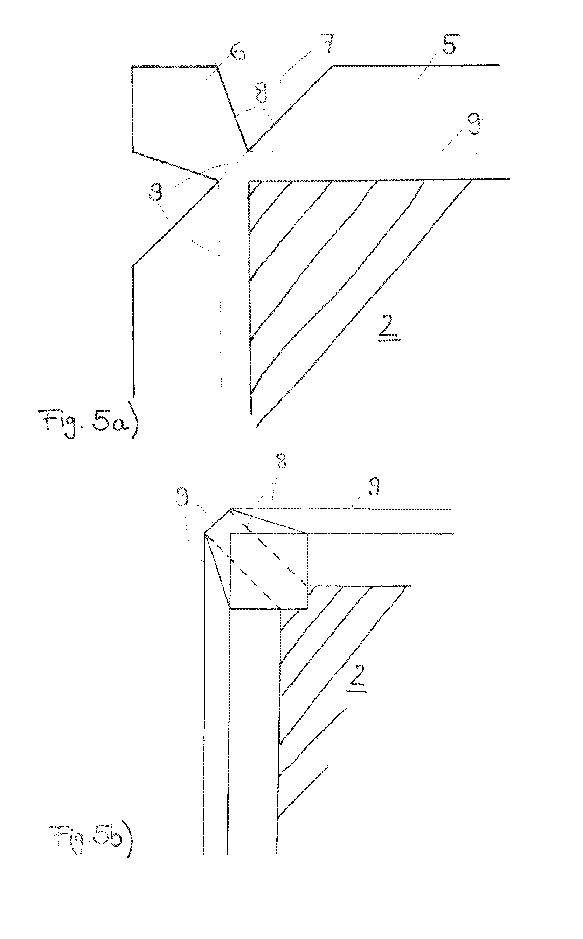

Figur 5a und 5b zeigen eine bevorzugte Ausführungsform. Figur 5a zeigt wiederum eine Aufsicht der Solarzelle abgewandten Seite des Träger eines erfindungsgemässen Moduls vor dem Anbringen der Seitenlaschen und der Ecklaschen auf dem Träger. In Figur 5b zeigt das Modul nach dem Falten der Seitenlaschen und der Ecklasche über die entsprechenden Faltlinien. Weiter ist ersichtlich, dass die Seitenkanten der Ecklaschen die entsprechenden Seitenkanten der benachbarten Seitenlaschen überlappen, insbesondere entlang der gesamten Seitenkante der Seitenlaschen. Dies führt im Überlappungsbereich zu einer weiteren Erhöhung des Diffusionswegs zur Solarzelle für eindringende Flüssigkeit. Es kann selbstverständlich auch aus vorgehend genannten Gründen vorteilhaft sein, dass die Seitenkanten der Seitenlaschen die entsprechenden Seitenkanten der benachbarten Ecklaschen überlappen, insbesondere entlang der gesamten Seitenkante der Ecklaschen.

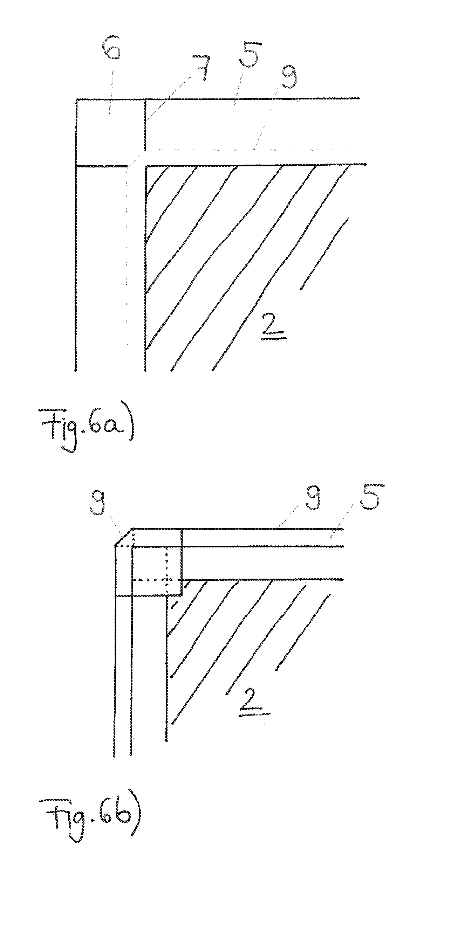

Figur 6a und 6b zeigen eine weitere Ausführungsform. Auch Figur 6a zeigt Seitenlaschen 5 und Ecklaschen 6 vor dem Anbringen auf dem Träger 2. Bei der Aussparung 7 handelt es sich um einen eigentlichen Schnitt in der Deckschicht bis zur Faltlinie 9 der Seiten-, resp. Ecklasche, welcher ohne Heraustrennen von Material aus der Deckschicht eine Aussparung und somit die Seitenkanten 8 der benachbarten Seiten- und Ecklasche bildet. Vorzugsweise weist die Aussparung jedoch einen Winkel von 5° ― 45°, gemessen von der Faltline der angrenzenden Seitenkante aus gemessen und begrenzt durch die beiden angrenzenden Seitenkanten 8, auf. Figur 6b zeigt das Modul nach dem Falten der zweiten Seitenlasche auf die Erste und anschliessendem Falten der Ecklasche darauf. Auch hier werden die entsprechenden Seitenkanten von der Ecklasche überlappt, insbesondere entlang der gesamten Seitenkante der Seitenlaschen. Dies führt wiederum zu dem bereits in Figur 5c erwähnten Vorteil.

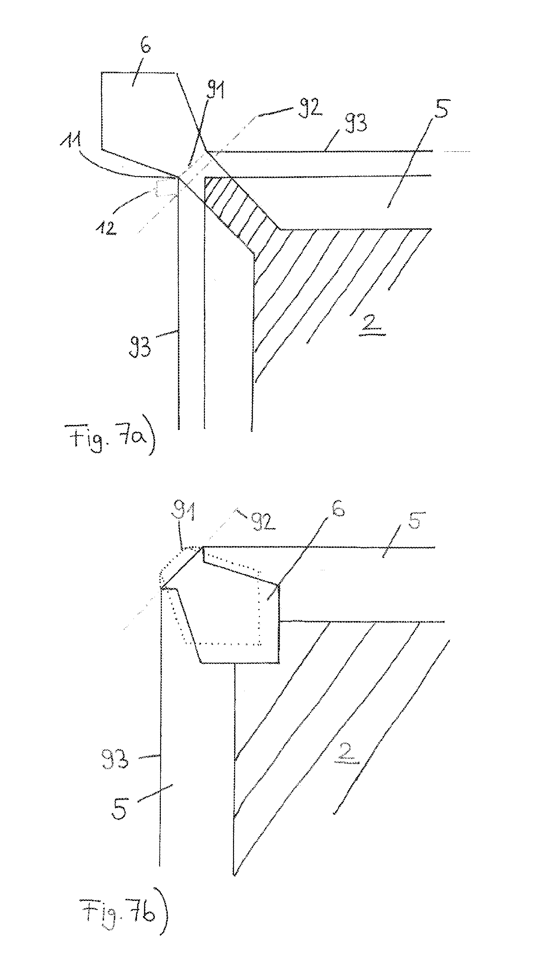

Eine weitere bevorzugte Ausführungsform der Erfindung ist in den Figuren 7a und 7b dargestellt. Figur 7a entspricht Figur 5a nach dem Falten der Seitenlaschen um die Faltlinie 93. Die gestrichelte Faltlinie 91 zeigt die Anordnung der in Figur 5b verwendeten Faltlinie der Ecklasche 6 an, während die Faltlinie 92 der Ecklasche die Faltlinie 93 der benachbarten Seitenlaschen schneidet. Vorzugsweise schneidet die Faltlinie der Ecklasche die Faltlinie der Seitenlasche an einer Stelle, die 3 - 15 mm entfernt ist, vom Berührungspunkt 11 der Seitenkanten 8 der entsprechenden Seitenlasche 5 und Ecklasche 6 aus gemessen. Der Abstand 12 beträgt also, wie vorgehend erwähnt, vorzugsweise 3 - 15 mm.

In Figur 7b ist die in Figur 5c gezeigte Anordnung der Ecklasche mit gepunkteten Linien angedeutet. Der Berührungspunkt 11, in dem die Aussparung 7 auf die Faltlinien 9 trifft, respektive wo die Seitenkanten 8 der entsprechenden Seiten- und Ecklasche aufeinandertreffen, ist anfällig für eindringende Flüssigkeit. Durch das Verschieben der Faltlinie der Ecklasche in Richtung des Mittelpunkts des Trägers, wie dies durch das Verschieben der Faltlinie 91 zur Faltlinie 92 gezeigt ist, wird dadurch der Diffusionsweg zur Solarzelle für eindringende Flüssigkeit weiter erhöht.

Weiter kann es von Vorteil sein, dass die Faltlinien 9 einen Mindestabstand von 2-10 mm vom Träger 2 aufweisen. Dies ist produktionstechnisch vorteilhaft.

Die Deckschicht 4 und der Träger 2, insbesondere die Seitenlaschen 5 und die Ecklaschen 6 und die der Solarzelle 3 abgewandte Seite des Trägers 2 können direkt miteinander verbunden sein. Unter "direkt verbunden" wird verstanden, dass keine weitere Schicht oder Substanz zwischen zwei Werkstoffen vorliegt und dass die zwei Werkstoffe direkt miteinander verbunden sind, beziehungsweise aneinander haften.

Dies kann insbesondere dadurch erfolgt sein, dass bei der Herstellung der direkte Verbund durch Wärmeeinwirkung, durch Druck, durch physikalische Absorption oder durch jede andere physikalische Krafteinwirkung erreicht wird. Dies hat insbesondere den Vorteil, dass keine chemische Verbindung mittels Klebstoffen notwendig ist, was sich vorteilhaft auf die Herstellungskosten des Moduls 1 auswirkt.

Es besteht jedoch auch die Möglichkeit, die Deckschicht 4 und den Träger, insbesondere die Seitenlaschen 5 und die Ecklaschen 6 und die der Solarzelle 3 abgewandte Seite des Trägers 2, durch eine Klebschicht zu verbinden. Ein in einer solchen Klebschicht verwendeter Klebstoff kann beispielsweise ein Haftklebstoff und/oder ein Schmelzklebstoff sein. Dies gewährleistet einen guten Verbund und gewährleistet einen zusätzlichen Schutz vor dem Eindringen von Feuchtigkeit.

Haftklebstoffe und Schmelzklebstoff sind dem Fachmann allgemein bekannt und sind beschrieben in CD Römpp Chemie Lexikon, Version 1.0, Georg Thieme Verlag 1995, Stuttgart.

Vorzugsweise handelt es sich bei einem solchen Klebstoff um Klebstoffe ausgewählt aus der Gruppe bestehend aus Ethylen/Vinylacetat-Copolymer (EVA), vernetzbare thermoplastische Elastomere auf Olefinbasis, Acrylatverbindungen, Polyurethanpolymeren und Silan-terminierten Polymeren.

Bevorzugte Acrylatverbindungen sind insbesondere Acrylatverbindungen auf Basis von Acryl-Monomeren, insbesondere von Acryl- und Methacrylsäureestern.

Der Begriff "Polyurethanpolymer" umfasst sämtliche Polymere, welche nach dem so genannten Diisocyanat-Polyadditions-Verfahren hergestellt werden. Dies schliesst auch solche Polymere ein, die nahezu oder gänzlich frei sind von Urethangruppen. Beispiele für Polyurethanpolymere sind Polyether-Polyurethane, Polyester-Polyurethane, Polyether-Polyharnstoffe, Polyharnstoffe, Polyester-Polyharnstoffe, Polyisocyanurate und Polycarbodiimide.

Besonders bevorzugt als Klebstoff ist Ethylen/Vinylacetat-Copolymer (EVA).

Weiter bevorzugt sind Klebstoffe, welche sich durch eine hohe Transmission im Bereich des Spektrums der gängigen Solarzellen und eine hohe UV-Stabilität auszeichnen, insbesondere wenn der Klebstoff auch die Deckschicht 4 mit der Solarzelle 3 verbindet.

Typischerweise handelt es sich bei der Deckschicht 4 um eine Schicht aus einem Kunststoff, welche sich durch eine hohe Transmission im Bereich des Spektrums der gängigen Solarzellen auszeichnen.

Vorzugsweise beträgt die Transmission des Materials der Deckschicht, gemessen bei einer Deckschichtdicke von 0.1 mm in einem Spektrum von 300-1300 nm, mehr als 85%, insbesondere mehr als 90%, insbesondere bevorzugt mehr als 93%.

Geeignete Materialien für die Deckschicht sind Fluoropolymere wie Copolymere von Ethylen and Tetrafluoroethylen, wie es beispielsweise von DuPont Corporation unter dem Handelsnamen Tefzel® vertrieben wird oder ein Polyvinylidenfluorid, vertrieben von der DuPont Corporation unter dem Handelsnamen Tedlar®.

Eine solche Deckschicht ist dahingehend von Vorteil, dass sie die Solarzelle vor Beschädigung, Verschmutzung sowie vor Eindringen von Flüssigkeit schützen kann.

Die Deckschicht weist typischerweise eine Dicke von 0.01 - 0.1 mm, bevorzugt 0.02 - 0.05 mm auf.

Unter dem Begriff "Solarzelle" werden in diesem Dokument sowohl eine einzelne Solarzelleneinheit als auch eine Vielzahl von untereinander elektrisch und/oder mechanisch verbundenen Solarzelleneinheiten verstanden. Solche Solarzelleneinheiten sind beispielsweise kommerziell erhältlich bei Clean Venture 21 Japan, Fuji Electric Japan, United Solar Ovonic LLC USA, Helianthos BV, Niederlande, VHF-Flexcell, Schweiz und Ascent Solar, USA.

Unter dem Begriff "Solarzelleneinheit" wird in diesem Dokument ein Halbleiterbauelement verstanden, das einen pn-Übergang enthält, in dem Sonnenlicht direkt in elektrische Energie umgewandelt wird, wie es beschrieben ist in CD Römpp Chemie Lexikon, Version 1.0, Georg Thieme Verlag 1995, Stuttgart.

Bei dem erwähnten Träger handelt es sich typischerweise über einen flexiblen Träger aus Kunststoff oder Metall, vorzugsweise aus einer korrosionsbeständigen Stahl- oder Aluminium-Legierung.

Selbstverständlich ist die Erfindung nicht auf die gezeigten und beschriebenen Ausführungsbeispiele beschränkt.

### Bezugszeichenliste

- 1: Modul
- 2: Träger
- 3: Solarzelle
- 4: Deckschicht
- 5: Seitenlaschen
- 6: Ecklaschen
- 7: Aussparungen
- 8: Seitenkante
- 9: Faltlinie
- 10: Eindringende Feuchtigkeit
- 11: Berührungspunkt der Seitenkanten
- 12: Abstand

## Patentansprüche

1. Modul (1) umfassend mindestens eine auf einem Träger (2) angeordnete Solarzelle (3), sowie eine Deckschicht (4), welche auf der dem Träger (2) abgewandten Seite der Solarzelle (3) angebracht ist, **dadurch gekennzeichnet, dass** die Deckschicht (4) Seitenlaschen (5) Ecklaschen (6) und Aussparungen (7) aufweist, wobei eine Aussparung (7) jeweils eine Seitenkante (8) einer Seitenlasche (5), resp. Ecklasche (6) bildet und die Seitenlaschen (5) und Ecklaschen (6), durch eine entsprechende Faltlinie (9) getrennt, auf der der Solarzelle (3) abgewandten Seite des Trägers (2) angeordnet sind, wobei die von einer Aussparung (7) gebildeten Seitenkanten der entsprechenden Seitenlasche (5) und Ecklasche (6) miteinander in Kontakt sind.

2. Modul (1) gemäss Anspruch 1, **dadurch gekennzeichnet, dass** die Seitenkanten (8) der Ecklaschen (6) die entsprechenden Seitenkanten (8) der benachbarten Seitenlaschen (5) überlappen, insbesondere entlang der gesamten Seitenkante der Seitenlaschen (5) überlappen.

3. Modul (1) gemäss Anspruch 1 oder 2, **dadurch gekennzeichnet, dass** die Faltlinie (9) der Ecklaschen (6) die Faltlinie (9) der benachbarten Seitenlaschen (5) schneidet, insbesondere an einer Stelle der Faltlinie der Seitenlasche, die 3-15 mm, vom Berührungspunkt (11) der Seitenkanten (8) der entsprechenden Seitenlasche (5) und Ecklasche (6) aus gemessen, entfernt ist.

4. Modul (1) gemäss einem der vorgehenden Ansprüche, **dadurch gekennzeichnet, dass** die Faltlinien (9) einen Mindestabstand von 2 -10 mm vom Träger (2) aufweisen.
